Europäisches Patentamt

European Patent Office

Office européen des brevets

(11) Publication number: **0 095 235**
A2

# (12) EUROPEAN PATENT APPLICATION

(21) Application number: 83301870.8

(22) Date of filing: 31.03.83

(51) Int. Cl.³: **G 03 F 7/04**

(30) Priority: 26.05.82 GB 8215360

(43) Date of publication of application:
30.11.83 Bulletin 83/48

(84) Designated Contracting States:
BE CH DE FR GB IT LI NL SE

(71) Applicant: AUTOTYPE INTERNATIONAL LIMITED
Grove Road
Wantage Oxon OX12 7BZ(GB)

(72) Inventor: Seaborne, Melvin Arthur
37 Donnington Place
Wantage Oxon(GB)

(72) Inventor: Balfour, Ross Alexander
36 Mallard Way
Grove Wantage Oxon(GB)

(74) Representative: Oliver, Roy Edward et al,
POLLAK MERCER & TENCH High Holborn House 52-54
High Holborn
London WC1V 6RY(GB)

(54) Etching resists.

(57) Photo-sensitive gelatine resists are made with gelatine which has been reacted with an acid-producting reactant, such as isocyanic acid or an isocyanate, so that the amino-groups of the gelatine are blocked from participating in dark reactions. Improved shelf-like characteristics are obtained.

EP 0 095 235 A2

Croydon Printing Company Ltd.

- 1 -

ETCHING RESISTS

DESCRIPTION

This invention relates to etching resists based upon gelatine. The use of light-sensitive pigmented gelatine coatings has long been an established practice in the preparation of etching resists. Principally, this is due to the excellent adhesion to clean copper surfaces which gelatine exhibits and also to the very fine differential control during the etching stage which gelatine offers, alone among water-soluble colloids. Gelatine-based resists are of particular utility in the preparation of rotary photogravure printing cylinders and plates.

Gelatine can be rendered light-sensitive for this purpose in two main ways, by the use of either an inorganic dichromate salt or an ethylenically-unsaturated monomer in association with an organic photoinitiator.

Dichromate sensitisation can be effected either by absorbing the dichromate salt into a layer of gelatine coated upon film or paper or by including the dichromate salt in the gelatine solution at the coating stage; this sensitising method is extensively reviewed by Kosar in "Light-Sensitive Systems" (Wily, 1966). Monomer sensitisation involves dispersing fine droplets of the selected monomer into a gelatine solution and then adding an organic photoinitiating system activatable by actinic radiation, prior to coating the composition upon a film support; this latter method is disclosed in GB-PS 1,290,727, 1,291,970 and 1,483,391.

In use in conventional gravure work, two exposures to actinic light are made on to the photosensitive resist layer. One exposure is made through a conventional white-line screen and is followed by another exposure made through a continuous tone diapositive. The surface to be etched is then moistened and the exposed layer is transferred, e.g. by roller pressure on the paper or film, with the gelatine in contact with the moistened copper surface. The film or paper backing is then removed and, in the case of a dichromate-sensitised resist, the unexposed colloid is developed away with water at about 45°C. The remaining image is then dried and subsequently treated with a ferric chloride etchant, which differentially penetrates the resist to produce an intaglio printing surface on the metal cylinder. In the case of a monomer-containing sensitised system, the development step is omitted; the resist is simply transferred to the cylinder in the manner described and subsequently etched directly.

In either of the main forms described, the known process is limited by the instability of the gelatine-dichromate or gelatine-monomer mixture. In the former case, a dark reaction takes place at ordinary temperatures, causing hardening of the sensitised resist within a few days. This increases the photographic speed uncontrollably and ultimately renders the whole of the coating insoluble in the developing step. It is therefore necessary either to use dichromate-sensitised resist material within a few hours or days of preparation or to store the sensitised material at low temperature, typically -20°C.

In the case of the gelatine monomer mix, the dark reaction takes place quickly and the resist then cannot be developed because of insolubility. It is necessary to employ a high proportion of monomer to gelatine, so that differential photohardening can still occur, and to omit the development stage. Because of the very hard photoresist ultimately formed, the etchant is very slow to penetrate the layer and etching times are inordinately long and may result in unsatisfactory control over tonal gradation.

It is generally accepted that the photochemical principle on which the dichromate process works is that exposure to actinic light reduces chromium VI in the dichromate to chromium III, which can then react with active groups in the gelatine molecule (thought to be principally the carboxylic acid groups), thus forming an insoluble layer in the exposed region. The dark reaction is believed to be caused by active functional groups in the gelatine, probably $-NH_2$ groups, slowly causing chemical reduction of the chromium VI ions to chromium III, even in the absence of light. The $-NH_2$ groups are also believed to cause the crosslinking reaction in the presence of monomers, causing rapid insolubilisation of the coating in the case of the gelatine-monomer combination.

Many attempts have been made to improve the stability of the dichromate-sensitised system. These include, for example, raising the pH of the coating emulsion (as described by Kosar), storing the sensitised material in an atmosphere of dry ammonia gas (JP-PS 7,664,918) and adding complexing agents, such as citric, oxalic or tartaric acid (FR-PS 1,572,207). These practices considerably reduce the sensitivity of the layer and thus increase, to a prohibitive level, the exposure times necessary for the preparation of etching resists.

The resultant gains in shelf-life are also restricted by the fact that the sequestering agent gradually becomes saturated by reduced chromium ions and, when this happens, the normal rapid ageing proceeds.

It has now been discovered that certain chemically-modified gelatines allow the preparation of presensitised etching resists which are substantially improved as regards the shelf-life stability of the sensitised product at normal ambient temperatures.

According to this invention, a photocrosslinkable material, suitable for use as an etching resist, comprising a support bearing a layer of a photosensitised gelatine composition, is characterised in that the gelatine has been modified by treatment with a reactant which causes substitution of the amino-groups of the gelatine.

Gelatines so modified in order to be utilisable in accordance with the invention are unable to undergo the dark reaction which produces tanning. Preferably, the reactant is isocyanic acid, which has proved to be of particular utility. Other examples of suitable modified gelatines are those prepared by reaction with organic anhydrides, for example phthalic or succinic anhydride (see US-PS 2,525,753) or by reaction with organic acid chlorides. Modification can also be effected by reacting gelatine with isocyanates, e.g. alkali metal isocyanate or phenyl isocyanate, the latter of which converts the amino-groups to phenyl-urea derivatives (see US-PS 2,592,263).

In many cases, the modification may result in coacervation of the gelatine at low pH values. This property unfortunately adversely affects penetration of the etchant due to lack of swelling of the resist in the acid conditions involved, particularly in highlight areas. This results in long etching times and an unacceptable gradation between the highlight and shadow areas of a ——————————————————

printing plate or cylinder produced using these gelatines. A very high contrast may be produced and loss of shadow tone separation may result. In order to achieve an acceptable compromise between stability and satisfactory highlight etching characteristics, the chemically-modified gelatines may be mixed with unsubstituted gelatines, so as to modify their etching characteristics, although this results in some reduction in the shelf-life of the product.

It has further been discovered that certain of these chemically-modified gelatines are capable of providing substantial improvement in shelf-life of the sensitised product, as already indicated, with surprisingly little increase in the time taken to etch through the resist and also with excellent tonal gradation etching characteristics.

The preferred modification of the gelatine employed in carrying out the invention involves treatment with isocyanic acid, which most advantageously is developed in situ from a suitable salt or other compound which may be caused to release isocyanic acid in a controlled fashion. The isocyanic acid converts free amino-groups in the gelatine to the corresponding unsubstituted urea. This causes blocking of the dark reaction described above and the gelatine so modified readily allows controlled penetration of a ferric chloride etchant, resulting in very good etching characteristics, because coacervation at low pH values is avoided. The preparation of gelatines modified by reaction with isocyanic acid or its precursors is disclosed in US-PS 2,816,099; the use of such modified gelatines in etch resists has not previously been proposed.

One important benefit of using gelatines in which the amino-groups are modified is that, when used with an organic photoinitiating system, selection of suitable ethylenically-unsaturated monomers avoids insolubility in the gelatine layer. A photoresist may then be produced which has a good shelf-life and also exhibits normal etching times with improved tonal control.

The coated products described above normally contain such additives as pigments, plasticisers and surface-active agents.

In the preferred embodiment of a photocrosslinkable material according to this invention, the support comprises film or paper coated with the chemically-modified gelatine, the support being strippable from the photocrosslinkable layer. The gelatine may be sensitised by conventional means, suitable sensitisers including both inorganic dichromate salts and solutions or dispersions of ethylenically-unsaturated monomers, together with photoinitiating systems activable by actinic radiation.

In order that the invention may be fully understood, a number of Examples are given, by way of illustration only; Examples 1 and 5 represent aspects of the prior art and Examples 2 to 4 and 6 are representative of the invention.

EXAMPLE 1

| | |
|---|---|
| 240 g bloom limed ossein gelatine | 90 g |
| Water | 350 g |
| Glycerine | 15 g |
| "Luconyl Brown 295" * | 8 g |
| Potassium dichromate | 6 g |

* "Luconyl" is a brand name of BASF.

The above ingredients were mixed together for 2 minutes at 45$^{O}$C on a high shear mixer, after which time the resultant emulsion was adjusted to neutral pH. The mixture was then coated on to a strippable support consisting of either a photographic paper of 140 gsm or a suitably subbed polyester film of 125 μ thickness, so as to give a dry coating thickness of 45 μ.

Exposure of samples of the resultant film was carried out using a white line gravure screen (60 lines/cm), using a Berkey "Addalux" 2 Kw metal halide light source for 3½ minutes at 120 cm, followed by an equal exposure to a gravure grey step-wedge incorporating a range of optical transmission densities from 1.75 to 0.30.

The exposed emulsion was transferred to a chemically-cleaned copper surface, in the normal way, and a resist was produced by development in water at 45$^{O}$C. This was etched in "Blue Label" (trade name of N V Hunt Chemical) ferric chloride etchant adjusted to 39.2$^{O}$ Baumé at 21$^{O}$C, whereupon etching was complete in 300 s, corresponding to a positive highlight density of 0.3.

The sensitive coating was held at 21$^{O}$ ± 1$^{O}$C/60% ± 5% relative humidity and the above process was carried out at regular intervals on different samples of the film. It was found possible to produce developed resists for up to 4 days, but beyond this point the coating had become insoluble and was no longer of use for this process.

EXAMPLE 2

An emulsion was prepared and coated in the manner described in Example 1 above, in which the gelatine was modified by reaction with phthalic anhydride to a degree of substitution of 98% of available $-NH_2$ groups.

The coating, processed as described in Example 1, gave an etching time for the 0.3 density factor of 1000 secs under identical circumstances. However, resists could be developed for etching purposes for 10 days, holding the coatings in the conditions specified in Example 1. Modification of the gelatine with phthalic anhydride substantially increases the period of usefulness of the resist material.

EXAMPLE 3

An emulsion was prepared and coated in the manner described in Example 1 above, in which the gelatine was modified by reaction with phenyl isocyanate to a degree of substitution of 97% of available $-NH_2$ groups.

The coating, processed as described in Example 1, gave an etching time for the 0.3 density factor of 2000 secs and resists could be developed for etching for up to 12 days of storage in the specified conditions.

EXAMPLE 4

An emulsion was prepared and coated in the manner described in Example 1 above, in which the gelatine was modified by reaction with potassium isocyanate to a degree of substitution of 98% of available $-NH_2$ groups.

The coatings, processed as described in Example 1, gave an etching time for the 0.3 density factor of 500 secs and produced developable resists for 20 days.

EXAMPLE 5

SOLUTION 1

| | |
|---|---|
| 240 g bloom limed ossein gelatine | 50 g |
| Water | 500 g |
| Diethylene glycol | 5 g |
| Victoria Blue B | 0.3 g |
| (C.I. 44055) | |

SOLUTION 2

| | |
|---|---|
| Pentaerythritol triacrylate | 30 g |
| 2-chlorothioxanthone | 0.05 g |
| Ethyl-o-dimethylaminobenzoate | 0.10 g |

Solutions 1 and 2 were made up separately and then blended on a high speed, high shear disperser at 45°C, to produce a uniform emulsion of the oil phase in the gelatine solution. The pH was adjusted to neutral and the mixture was coated on to a suitable subbed polyester support to produce a dry thickness of 25 μ.

Exposure was carried out as in Example 1, except that the time was 30 seconds in each case. The film was transferred to a clean copper surface and the support removed. The water development stage was omitted and the exposed layer was etched directly in "Blue Label" etchant adjusted to 40° Baumé at 20°C. Penetration of tones corresponding to the grey scale steps was as described in Table 1. Etching was continued to give an intaglio image. The following Table 1 gives a summary of the results obtained.

TABLE 1

| (1) OPTICAL TRANSMISSION DENSITY OF POSITIVE | (2) TIME OF ETCHANT PENETRATION (FRESH COATING) | (3) TIME OF ETCHANT PENETRATION (AGED) |
|---|---|---|
| 1.65 | 235 seconds | 545 seconds |
| 1.00 | 445 seconds | 895 seconds |
| 0.35 | 730 seconds | 1320 seconds |

After measuring the penetration times at the 3 respective transmission densities given in column (1), the times being as shown in column (2), the coatings were stored at $21^{\circ} \pm 1^{\circ}C$ and $60\% \pm 5\%$ RH for 24 hours and the above process was repeated, resulting in the increased etching times shown in column (3). These increases in time are due to the continuing interaction of the colloid and the monomer, producing reduced solubility.

EXAMPLE 6

An emulsion was prepared and coated as described in Example 5, except that a derivatised gelatine prepared by reaction with isocyanic acid (as described in US-PS 2,816,099) was employed.

Exposure and processing was carried out as described in Example 5, yielding the etching penetration times listed in Table 2.

| (1)<br>OPTICAL TRANSMISSION<br>DENSITY OF POSITIVE | (2)<br>TIME OF ETCHANT<br>PENETRATION<br>(FRESH COATING) | (3)<br>TIME OF ETCHANT<br>PENETRATION (AGED) |
|---|---|---|
| 1.65 | 255 seconds | 270 seconds |
| 1.00 | 480 seconds | 460 seconds |
| 0.35 | 750 seconds | 730 seconds |

In this case, the penetration times listed in column (3) relate to 20 days ageing in the conditions described in Example 5.

CLAIMS:

1. A photocrosslinkable material suitable for use as an etching resist, comprising a support bearing a layer of a photosensitised gelatine composition, characterised in that the gelatine has been modified by treatment with a reactant which causes substitution of the amino-groups of the gelatine.

2. A photocrosslinkable material according to claim 1, in which the reactant is isocyanic acid.

3. A photocrosslinkable material according to claim 1, in which the reactant is an organic acid chloride.

4. A photocrosslinkable material according to claim 1, in which the reactant is an organic acid anhydride.

5. A photocrosslinkable material according to claim 4, in which the organic acid anhydride is selected from phthalic ———— and succinic anhydrides.

6. A photocrosslinkable material according to claim 1, in which the reactant is an organic or inorganic isocyanate.

7. A photocrosslinkable material according to claim 6, in which the isocyanate is selected from phenyl isocyanate or potassium isocyanate.

8. A photocrosslinkable material according to any preceding claim, in which the photosensitised gelatine modified by treatment with the reactant and at least one unsubstituted gelatine are present in the layer.

9. A photocrosslinkable material according to any preceding claim in which the sensitiser for the gelatine is an inorganic dichromate salt.

10. A photocrosslinkable material according to any of claims 1 to 8, in which the sensitiser for the gelatine is a solution or dispersion of an ethylenically-unsaturated monomer.

11. A photocrosslinkable material according to claim 9 or 10, in which a photoinitiating system activable by actinic radiation is incorporated in the photosensitised gelatine layer.

12. A photocrosslinkable material according to any preceding claim, in which the support comprises film or paper and is strippable from the layer after exposure.